# EUROPEAN PATENT SPECIFICATION

(11) **EP 3 580 789 B1**
(45) Date of publication and mention of the grant of the patent: **18.11.2020**
(21) Application number: 18707470.3
(22) Date of filing: 08.02.2018
(51) Int. Cl.: H01L 35/32, B60N 2/56

(54) **THERMOELECTRIC MODULE**
THERMOELEKTRISCHES MODUL
MODULE THERMOÉLECTRIQUE

(30) Priority: 08.02.2017 US 201762456346 P
(43) Date of publication of application: 18.12.2019
(73) Proprietor: Magna Seating Inc., Aurora, Ontario L4G 7K1 (CA)
(72) Inventor: DAVIS, Jason, Commerce Township MI 48390 (US); STEPANOV, Artur, Auburn Hills MI 48326 (US); KOZLOWSKI, Eric, Oakland Township MI 48363 (US)
(74) Representative: Glawe, Delfs, Moll
(86) International application number: PCT/US2018/017409
(87) International publication number: WO 2018/148398

(56) References cited:
- FR-A1- 3 032 923
- GB-A- 912 001
- JP-A- 2001 119 076
- JP-A- 2004 193 209
- US-A1- 2009 000 309
- US-A1- 2015 287 901

## Description

### TECHNICAL FIELD

Example embodiments relate to a discrete thermoelectric module and a flexible thermoelectric circuit assembly incorporating the discrete thermoelectric modules. The thermoelectric module and flexible thermoelectric circuit assembly may be used for various cooling, heating and/or power generating applications.

### BACKGROUND

Thermoelectric circuits may be used for cooling, heating and/or power generating applications due to the Peltier effect whereby passing a current through the junction of two different conductive materials causes a heating or cooling effect. The conductive materials suitable for thermoelectric circuits are typically rigid and relatively fragile or brittle materials.

GB 912,001 discloses a thermoelectric assembly comprising a generally egg-crate shaped structure of electrical and thermal insulating material having a plurality of open-ended compartments extending from one side to the opposite side thereof, at least one thermoelectric element disposed in each compartment, each of the elements having two end faces disposed, respectively, in planes common to the corresponding end faces of the other elements, the planes coinciding substantially with the planes containing the sides of the egg-crate shaped structure, electrically arid thermally conductive means joined to the end faces of the thermoelectric elements in predetermined arrays to form hot junctions in one of the common planes and cold junctions in the oher common plane, and a pair of heat-conductive plates sandwiching the structure therebetween, the plates being disposed in good heat exchange contact with the conductive means forming the hot and cold junctions, respectively.

### SUMMARY

According to one embodiment, there is provided a thermoelectric module comprising the features of claim 1.

### BRIEF DESCRIPTION OF THE DRAWINGS

Advantages of the present invention will be readily appreciated as the same becomes better understood by reference to the following detailed description when considered in connection with the accompanying drawings wherein:
Figure 1A is a front cross section view of a thermoelectric module in accordance with one embodiment of the present disclosure and Figure 1B is a front cross section view of a portion of a flexible thermoelectric circuit assembly including a heat sink and the thermoelectric module of Figure 1A;
Figure 2 is a bottom perspective view of one embodiment of a flexible circuit panel for a flexible thermoelectric circuit assembly;
Figure 3A is a top perspective view of the flexible thermoelectric circuit assembly and Figure 3B is a bottom perspective view of the flexible thermoelectric circuit assembly;
Figure 4 is a front cross section view of a thermoelectric module in accordance with another embodiment of the present disclosure;
Figures 5A and 5B are top and bottom perspective views of the base of the thermoelectric module of Figure 4;
Figure 6 is a front cross section view of a portion of a flexible thermoelectric circuit assembly including a heat sink and the thermoelectric module of Figure 5;
Figure 7A is a front cross section view of a thermoelectric module in accordance with another embodiment of the present disclosure; Figures 7B and 7C are top and bottom perspective views of the thermoelectric module of Figure 7A;
Figure 8 is a front cross section view of a thermoelectric module in accordance with another embodiment of the present disclosure;
Figure 9 is a bottom perspective view of a flexible thermoelectric circuit assembly in accordance with another embodiment of the present disclosure.
Figure 10 is a front cross section view of a portion of one embodiment of the flexible thermoelectric circuit assembly mounted within a padding layer for a vehicle seat; and
Figure 11 is a front cross section view of a portion of another embodiment of the flexible thermoelectric circuit assembly mounted within a padding layer for a vehicle seat.

Like reference numerals are used throughout the Figures to denote similar elements and features.

### DETAILED DESCRIPTION OF EXAMPLE EMBODIMENTS

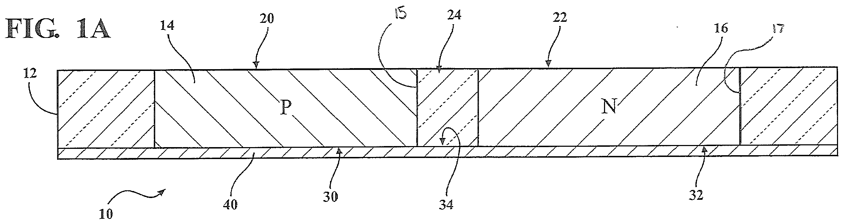

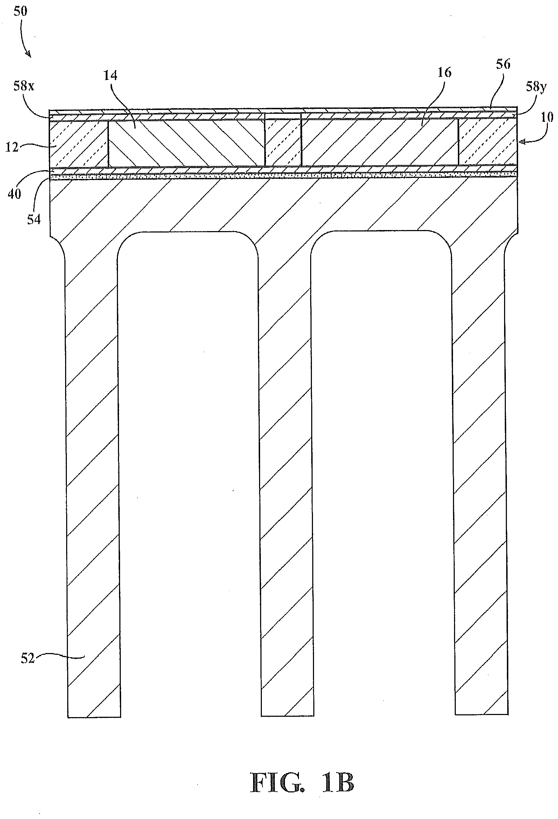

Figures 1 to 11 illustrate various thermoelectric modules and flexible thermoelectric circuit assemblies incorporating the thermoelectric modules according to embodiments described herein. Directional references employed or shown in the description, figures or claims, such as top, bottom, upper, lower, upward, downward, lengthwise, widthwise, left, right, and the like, are relative terms employed for ease of description and are not intended to limit the scope of the invention in any respect. For example, the figures illustrate thermoelectric modules and flexible thermoelectric circuit assemblies with heat sinks extending towards the bottom or towards the top of the figure. It will be readily apparent that the thermoelectric modules and flexible thermoelectric circuit assemblies according to the present disclosure may be oriented in any direction. Further, cross section views of the thermoelectric modules and flexible thermoelectric circuit assemblies are shown to illustrate their layers and components but such views are not necessarily to scale.

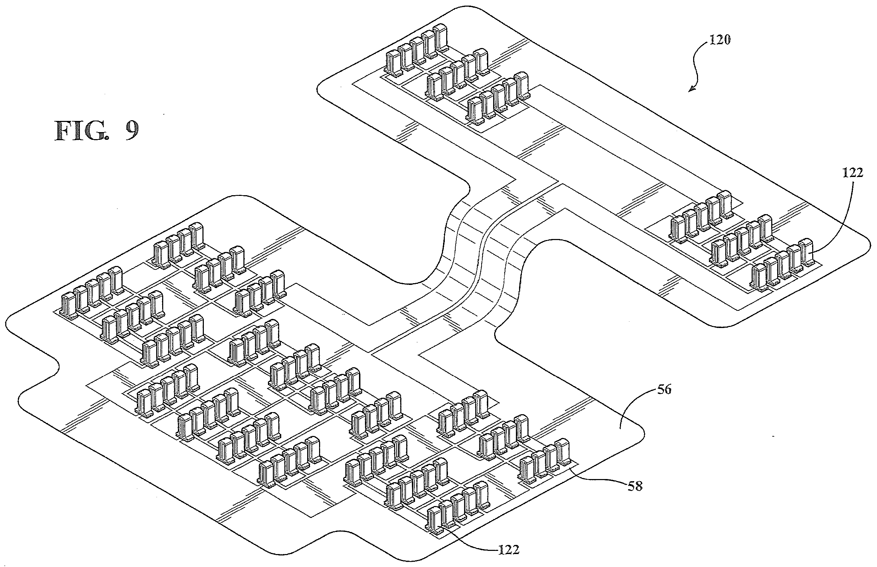

The thermoelectric modules described herein are discrete cooling, heating and/or power generating blocks or components which may be mounted to a flexible circuit panel to create a flexible thermoelectric circuit assembly. Alternatively, the thermoelectric modules may be electrically connected with wires, adhesives, foils, etc. to create a flexible thermoelectric circuit assembly. Each thermoelectric module is rigid to protect the thermoelectric materials contained therein, but the distribution of several thermoelectric modules over a flexible circuit panel results in a flexible thermoelectric circuit assembly. The flexible circuit panel may be sized and shaped to target a specific cooling, heating and/or power generating application. The flexible circuit panel also may be configured to support suitable numbers and locations or patterns of thermoelectric modules electrically connected in series and/or in parallel to achieve the desired thermoelectric performance. For example, as shown in Figure 9 and described later herein, the thermoelectric modules may be used along with heat sinks to create a flexible thermoelectric circuit assembly for heating and/or cooling a seat of a vehicle. It will be appreciated that other flexible thermoelectric circuit assemblies may be configured with different patterns using the same thermoelectric modules in order to target different seat assemblies. The same thermoelectric modules also may be used in flexible thermoelectric circuit assemblies configured for different vehicle parts such as steering wheels, or other seats, parts, or applications not limited to vehicles. The thermoelectric module thus provides a standard component which may be used across many applications, reducing the cost and complexity of flexible thermoelectric circuit assemblies.

Figure 1A illustrates one embodiment of a thermoelectric module 10 of the present disclosure. The thermoelectric module 10 includes a base 12 and two thermoelectric elements set in the base 12. A first thermoelectric element 14 is shown on the left in Figure 1A and a second thermoelectric element 16 is shown on the right. The base 12 is a rigid substrate which operates to protect the thermoelectric elements 14, 16. The base 12 may comprise a phenolic resin, epoxy resin, or glass-reinforced epoxy laminate material such as flame-retardant composite materials. For example, the base 12 may be made from NEMA (National Electrical Manufacturers Association) FR-1, FR-2 or FR4 laminate materials which are typically used to manufacture rigid printed circuit boards. Other rigid materials may be used for the base 12 provided that the material is electrically isolative and has minimal thermal conductivity. The base 12 may comprise a material or combination of materials including but not limited to polyetherimide (PEI), polyester terephthalate (PET), polybutylene terephthalate (PBT), or nylon. The base 12 may have a thermal conductivity below 0.25 W/mK.

The first and second thermoelectric elements 14, 16 may comprise various thermoelectric materials including but not limited to bismuth telluride (Bi₂Te₃), lead telluride (PbTe), or magnesium stannide (Mg₂Sn). One of the two thermoelectric elements is a P-type semiconductor and the other thermoelectric element is an N-type semiconductor, as is well known in the art. For ease of reference and illustration purposes, all embodiments of the thermoelectric modules are described and illustrated herein with the first thermoelectric element 14 being a P-type semiconductor and the second thermoelectric element 16 being an N-type semiconductor.

In one embodiment, the base 12 defines first and second apertures 15,17 which receive the first and second thermoelectric elements 14, 16. The thermoelectric elements 14, 16 and apertures 15,17 in the base 12 may be generally cylindrical. In other embodiments, the base 12 may define different sizes and shapes of apertures 15,17 for receiving different sizes and shapes of thermoelectric elements 14, 16. This may include but is not limited to square, rectangular or oval apertures 15,17 in the base 12 which receive corresponding square, rectangular or oval shaped thermoelectric elements 14, 16. Alternatively, the thermoelectric module 10 may have square or rectangular cuboid thermoelectric elements 14, 16 set in round or oval apertures 15,17 in the base 12. In one embodiment, the thermoelectric elements 14, 16 are generally free-floating within the apertures 15,17. Spaces may exist within the first and second apertures 15,17 between the base 12 and the first and second thermoelectric elements 14, 16. The first and second thermoelectric elements 14, 16 may have generally the same thickness as the base 12 such that a top surface 20 of the first thermoelectric element 14 and a top surface 22 of the second thermoelectric element 16 are coplanar or nearly coplanar with a top surface 24 of the base 12. Similarly, the first and second thermoelectric elements 14, 16 have respective bottom surfaces 30, 32 which are coplanar or nearly coplanar with a bottom surface 34 of the base 12.

The thermoelectric module 10 includes a bottom layer 40 which is coupled to the base 12 and to the first and second thermoelectric elements 14, 16. Specifically, the bottom layer 40 may be coupled to the bottom surface 34 of the base 12, the bottom surface 30 of the first thermoelectric element 14, and the bottom surface 32 of the second thermoelectric element 16. The bottom layer 40 is configured to create an electrical connection between the first and second thermoelectric elements 14, 16. In some embodiments, the bottom layer 40 also serves to mechanically link or connect the base 12 and the first and second thermoelectric elements 14, 16.

In one embodiment, the bottom layer 40 is an electrically conductive material, such as a layer of copper or aluminum which may be soldered to the bottom surfaces 30, 32 of the first and second thermoelectric elements 14, 16. Alternatively, an electrically conductive adhesive may be used. Such adhesives include but are not limited to epoxies, resins or silicones, each filled with silver, copper, aluminum, or iron. The bottom layer 40 may be attached or mounted to the bottom surface 34 of the base 12 with the same adhesive used for the thermoelectric elements 14, 16 or with a different adhesive such as a structural adhesive, including but not limited to Loctite® 3616 or Epotek® H70E-4. In some embodiments, (not shown) the bottom layer 40 may be configured with areas of electrically conductive material to cover the bottom surfaces 30, 32 of the first and second thermoelectric elements 14, 16 and to electrically connect the thermoelectric elements 14, 16. The bottom layer 40 may have non-electrically conductive material in other areas of the bottom layer 40 adjacent to the bottom surface 34 of the base 12.

Figure 1B illustrates a cross section of a portion of a flexible thermoelectric circuit assembly 50 incorporating the thermoelectric module 10 of Figure 1A. In the embodiment shown, the flexible thermoelectric circuit assembly 50 includes a heat sink 52 to remove or dissipate excess heat from the hotter side of the thermoelectric module 10. For some heating, cooling and/or power generating applications, the heat sink 52 is not necessary. The heat sink 52 may be comprised of any suitable material typically used for heat sinks such as copper, aluminum, or graphite. The heat sink 52 may be rigid or flexible and configured with various fins, sizes, and shapes. In some embodiments (not shown), the bottom layer 40 of the thermoelectric module 10 may be configured as a heat sink. This single bottom layer 40 would operate to electrically connect the first and second thermoelectric elements 14, 16 and to conduct and dissipate heat away from the thermoelectric module 10.

The flexible thermoelectric circuit assembly 50 may optionally include a dielectric layer 54 between the heat sink 52 and the thermoelectric module 10. The dielectric layer 54 is used to electrically isolate the heat sink 52 from the bottom layer 40 of the thermoelectric module 10 depending on the use or application for the flexible thermoelectric circuit assembly 50.

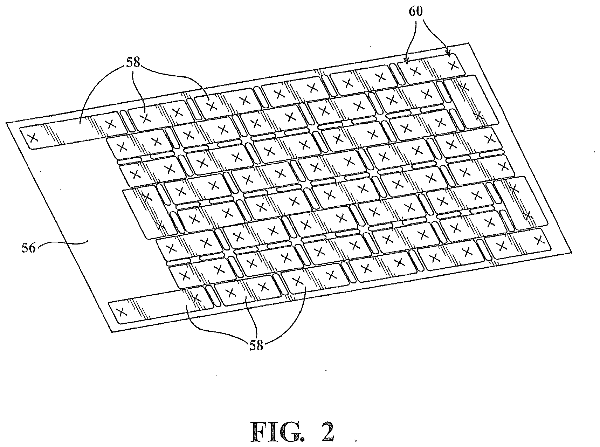

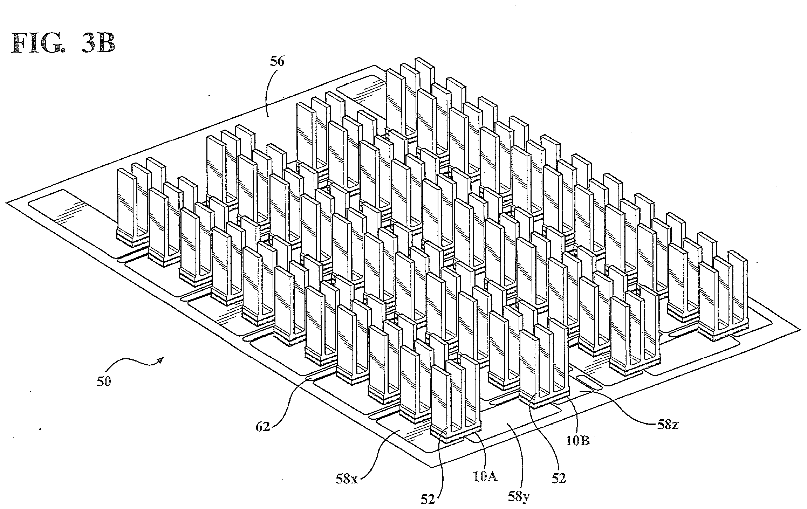

The flexible thermoelectric circuit assembly 50 includes a flexible circuit panel 56 which is configured with multiple circuit conductors 58 for mounting and connecting the thermoelectric modules 10. Specifically, as shown in Figure 2, each circuit conductor 58 comprises a layer of conductive material, such as copper, in a line or area which is configured next to one or more other circuit conductors 58. The circuit conductors 58 are sized and spaced such that the circuit conductors 58 are connected electrically by the placement of thermoelectric modules 10 spanning two adjacent circuit conductors 58. As shown in Figure 3B, for example, thermoelectric module 10A (with a heat sink 52 attached) spans across and is connected to circuit conductors 58x and 58y; and thermoelectric module 10B (with a heat sink 52 attached) spans across and is connected to circuit conductors 58y and 58z. The circuit conductors 58x, 58y and 58z are thus connected electrically in series by thermoelectric modules 10A and 10B. The first and second P-type and N-type thermoelectric elements 14, 16 in each thermoelectric module 10A and 10B are connected thermally in parallel to draw or dissipate heat away from the area adjacent the top of the flexible thermoelectric circuit assembly 50.

Returning to Figure 1B, it can be seen that a first circuit conductor, such as circuit conductor 58x, contacts the first thermoelectric element 14 in the thermoelectric module 10 and a second circuit conductor, such as circuit conductor 58y, contacts the second thermoelectric element 16 in the thermoelectric module 10. Thus, for a cooling application, for example, as current enters the flexible thermoelectric circuit assembly 50 and the first circuit conductor 58x, it travels through the first thermoelectric element 14 and then through the electrical connection provided by the bottom layer 40 to the second thermoelectric element 16. Current then travels from the second thermoelectric element 16 through the second circuit conductor 58y to the next thermoelectric module 10 connected to the second circuit conductor 58y. In other words, one part of the electrical connection of the flexible thermoelectric circuit assembly 50 is achieved by the connection of the bottom layer 40 and the other part of the electrical connection is made as the thermoelectric modules 10 are connected across two different circuit conductors 58 in the flexible circuit panel 56. Depending on the configuration of the flexible circuit panel 56 and circuit conductors 58, current may travel electrically in series or in parallel through the circuit created by the flexible circuit panel 56 and the thermoelectric modules 10.

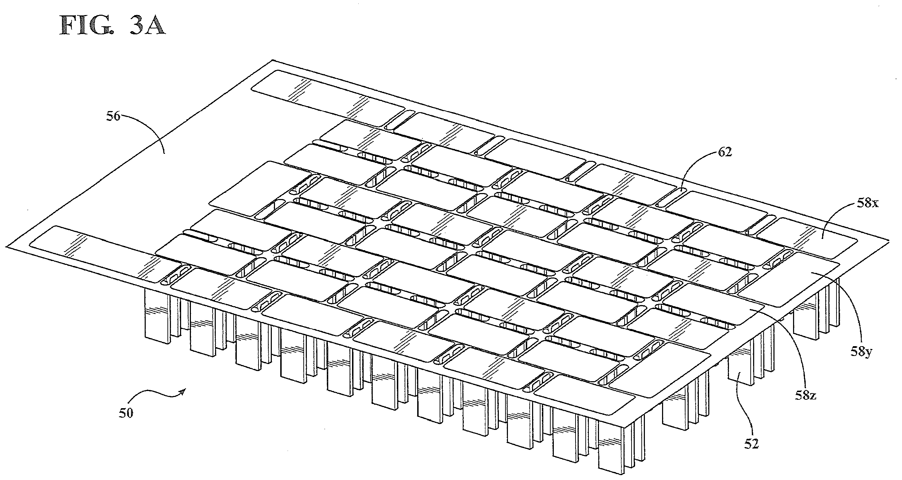

The circuit conductors 58 may be layers of copper or other electrically conductive material embedded in or bonded to the flexible circuit panel 56, as is known in the art. The circuit conductors 58 may include exposed connection points (identified as "X" in Figure 2) or solder pads 60 for mounting the thermoelectric modules 10, as shown in Figure 2. In some embodiments, other portions of the circuit conductors 58 are covered by a non-electrically conductive film to protect the circuit conductors 58 and isolate the flexible thermoelectric circuit assembly 50. In some embodiments, as shown in Figure 3A, the flexible circuit panel 56 may define one or more relief cuts or holes 62 to increase the potential flex of a particular portion of the flexible thermoelectric circuit assembly 50. Such relief cuts or holes 62 also may reduce the noise created by the flexible thermoelectric circuit assembly 50 as it flexes. It will be appreciated that other components may be included in the flexible thermoelectric circuit assembly 50, such as but not limited to, connectors and thermistors.

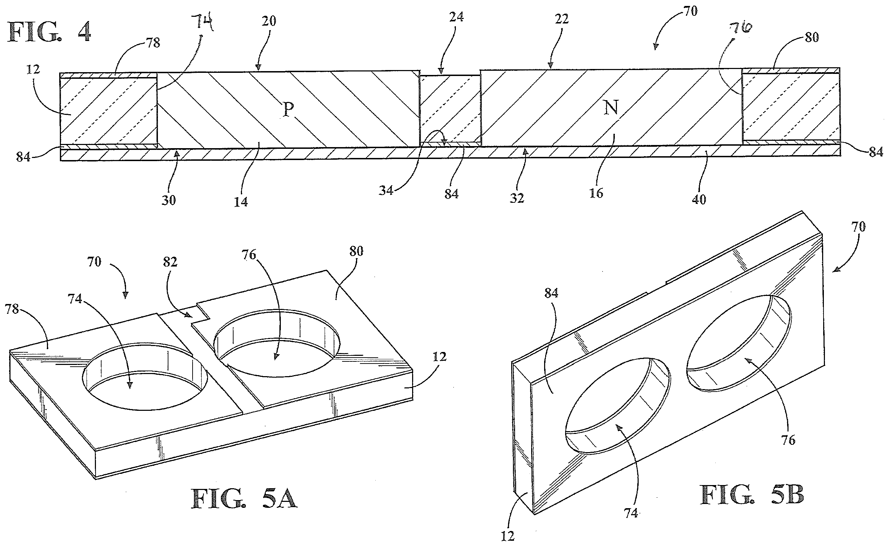

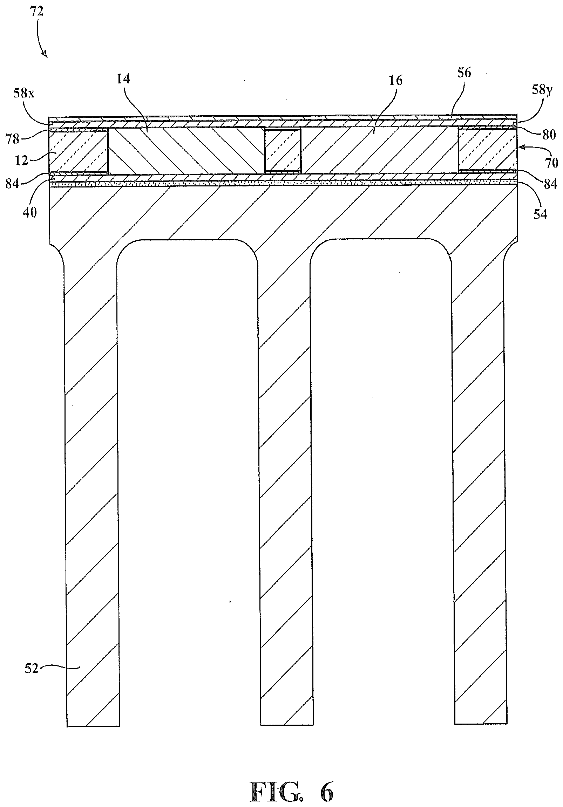

Figures 4, 5A, and 5B illustrate another embodiment of a thermoelectric module 70. Figure 6 illustrates a cross section of a portion of a flexible thermoelectric circuit assembly 72 incorporating the thermoelectric module 70 and heat sink 52. The thermoelectric module 70 includes a base 12 and two thermoelectric elements 14, 16 set in respective first and second apertures 74, 76 defined by the base 12. Additional link layers are provided for attaching the base 12 and the thermoelectric elements 14, 16 to the bottom layer 40 and/or to the flexible circuit panel 56 of the flexible thermoelectric circuit assembly 72. A link layer may be a layer of material which has been bonded to the base 12 or formed as part of the base 12. A link layer typically is comprised of metal, such as copper or aluminum, which is suitable for forming a solder connection between the base 12 and the bottom layer 40 or between the base 12 and the flexible circuit panel 56. Alternatively, electrically conductive adhesives may be used instead of solder connections.

Specifically, a first link layer 78 may be coupled to the top surface 24 of the base 12 adjacent to the first aperture 74 for the first thermoelectric element 14. A second link layer 80 may be coupled to the top surface 24 of the base 12 adjacent to the second aperture 76 for the second thermoelectric element 16. The first and second link layers 78, 80 may completely or partially surround each aperture 74, 76 and/or almost completely cover the top surface 24 of the base 12, as long as some separation is provided to electrically isolate the first link layer 78 from the second link layer 80. In this embodiment, the first and second thermoelectric elements 14, 16 may have generally the same thickness as the base 12, or may be slightly taller than the base 12 such that the top surfaces 20, 22 of the first and second thermoelectric elements 14, 16 are coplanar or nearly coplanar with the top surfaces of the first and second link layers 78, 80.

A non-symmetrical layer or distinctive shape or cut-out may be provided in one or all of the link layers in order to serve as an indication for the orientation and installation of the thermoelectric module 70 on the flexible circuit panel 56. For example, the second link layer 80 shown in Figure 5A includes a cut-out portion 82 on the side or half of the thermoelectric module 70 that contains the second thermoelectric element 16, which is the N-type element in the example shown.

When the thermoelectric module 70 is mounted to the flexible circuit panel 56, as described above and as shown in Figure 6, the first link layer 78 and first thermoelectric element 14 may be soldered to the first circuit conductor 58x. The second link layer 80 and second thermoelectric element 16 may be soldered to the second circuit conductor 58y. Alternatively, an electrically conductive adhesive or a combination of solder connections and adhesives may be used. The circuit conductors 58 may be sized larger than is needed for an electrical and thermal connection in order to also provide a physical connection between the flexible circuit panel 56 and the thermoelectric module 70. The flexible thermoelectric circuit assembly 72 optionally may include a heat sink 52 mounted to each thermoelectric module 70 and an optional dielectric layer 54 between the heat sink 52 and the bottom layer 40 of the thermoelectric module 70.

In some embodiments, a third link layer 84 is coupled to the bottom surface 34 of the base 12. The third link layer 84 may be bonded to and cover a substantial portion or the entire the bottom surface 34 of the base 12, as shown in Figure 5B. In this embodiment, the bottom layer 40 is soldered to the third link layer 84 to achieve a mechanical connection between the bottom layer 40 and the base 12. As described above, the bottom layer 40 is also soldered to the bottom surfaces 30, 32 of the first and second thermoelectric elements 14, 16 to create an electrical connection between the first and second thermoelectric elements 14, 16. Alternatively, an electrically conductive adhesive or a combination of solder connections and adhesives may be used to connect the bottom layer 40 to the third link layer 84 and to the first and second thermoelectric elements 14, 16. As noted above, the first and second thermoelectric elements 14, 16 may be slightly taller than the base 12 such that the bottom surfaces 30, 32 of the first and second thermoelectric elements 14, 16 are coplanar or nearly coplanar with a top surface of the third link layer 84.

The connections of the first and second link layers 78, 80 to the respective circuit conductors 58x, 58y on the flexible circuit panel 56 may result in the first and second link layers 78, 80 being electrically connected to the respective first and second thermoelectric elements 14, 16. Similarly, the connection of the third link layer 84 to the bottom layer 40 may result in the third link layer 84 being electrically connected to the first and second thermoelectric elements 14, 16. A primary function of the first, second and/or third link layers 78, 80, 84, however, is to increase the strength of the physical connections between the thermoelectric module 70 and the flexible circuit panel 56, and between the bottom layer 40 and the base 12.

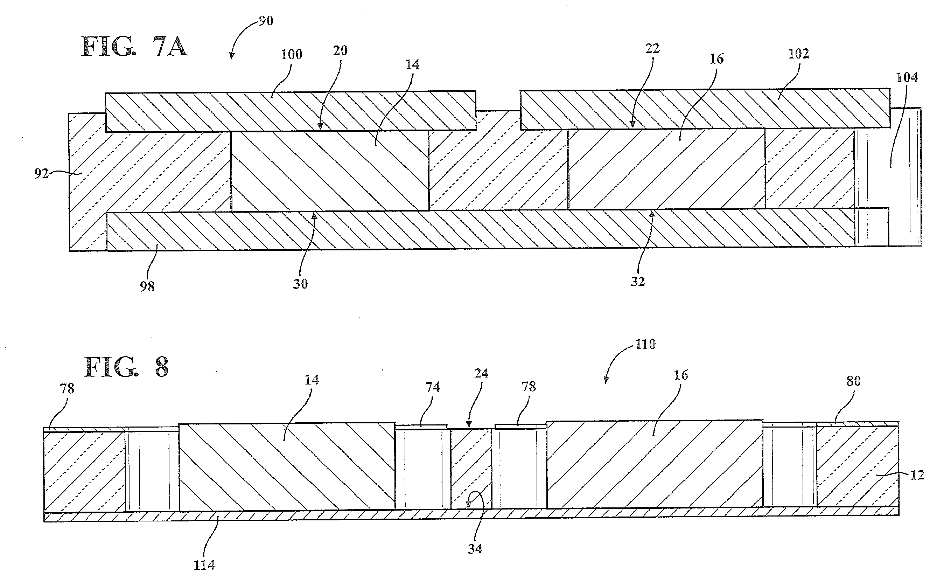

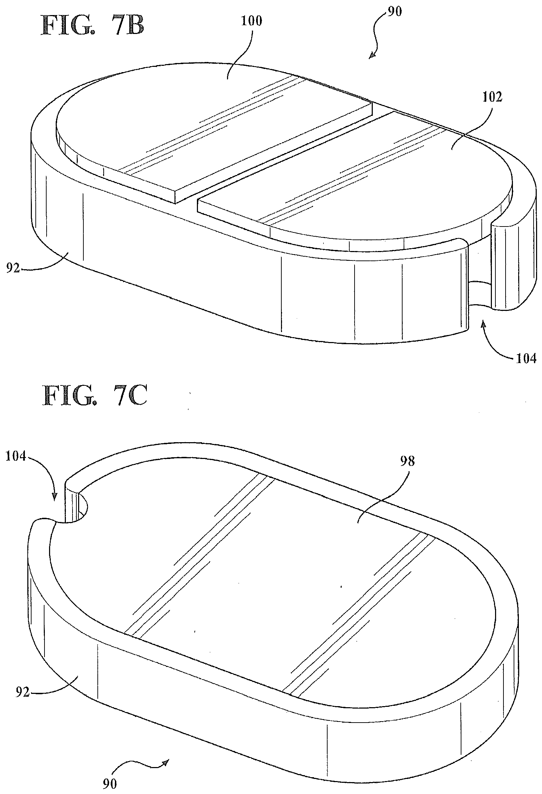

Figures 7A, 7B and 7C illustrate another embodiment of a thermoelectric module 90 according to the present disclosure. This embodiment includes a base 92, first and second thermoelectric elements 14, 16 and a bottom layer 98. A first thermoelectric module ("TM") conductor 100 is provided adjacent the top surface of the base 92 and is coupled to the first thermoelectric element 14. A second TM conductor 102 is provided adjacent the top surface of the base 92 and is coupled to the second thermoelectric element 16. The first and second TM conductors 100, 102 are electrically isolated from each other. The first and second TM conductors 100, 102 may be layers of conductive material such as copper or aluminum. As shown, the first and second TM conductors 100, 102 may be layers of conductive material which are attached to and cover the top surfaces of the first and second thermoelectric elements 14, 16. The first and second TM conductors 100, 102 also may overlap a portion or the entire top surface of the base 92 adjacent the respective first and second thermoelectric elements 14, 16 to contain or encapsulate each element. The first and second TM conductors 100, 102 thus may cover a substantial portion of the top surface of the base 92 in order to maximize the connection between the thermoelectric module 90 and the flexible circuit panel 56.

In some embodiments, (not shown) the first and second TM conductors 100, 102 may be separate, isolated areas of electrically conductive material configured within a single top layer of material which covers the top surfaces 20, 22 of the first and second thermoelectric elements 14, 16. The top layer also may cover all or a portion of the top surface of the base 92 and include non-electrically conductive material in other areas of the top layer adjacent to the top surface of the base 92.

The bottom layer 98 of the thermoelectric module 90 may be attached to and cover the bottom surfaces 30, 32 of the first and second thermoelectric elements 14, 16. The bottom layer 98 also may overlap a portion or all of the bottom surface of the base 92 adjacent each thermoelectric element 14, 16 to contain or encapsulate each element. The bottom layer 98 thus may cover a substantial portion of the bottom surface of the base 92 in order to maximize the connection between the thermoelectric module 90 and heat sink 52 (not shown). Again, in some embodiments (not shown), the bottom layer 98 may also be configured as the heat sink 52.

In some embodiments, a non-symmetrical layer or distinctive shape or cut-out may be provided in one or more of the base 92, the bottom layer 98, and/or the first and second TM conductors 100, 102 in order to serve as an indication for the orientation and installation of the thermoelectric module 90 on the flexible circuit panel 56. For example, a cut-out 104 is defined by the base 92 and the bottom layer 98 in the embodiment shown in Figures 7A-7C.

In the embodiment of Figures 7A, 7B and 7C, the base 92 may be formed by an injection molding process with a liquid substrate which is cured or set to provide the rigid base 92. The base 92 may be formed from a material or process such as but not limited to polyetherimide (PEI), polyester terephthalate (PET), polybutylene terephthalate (PBT), nylon, or Panasonic's ECOM series. The first TM conductor 100, the second TM conductor 102, and/or the bottom layer 98 in this embodiment may be thicker relative to other embodiments since these layers and conductors may be encapsulated and retained by portions of the base 92, as shown. Increasing the size and/or thickness of the first and second TM conductors 100, 102 and/or the bottom layer 98 may be done to optimize the thermal performance of the thermoelectric module 90 and to optimize the physical connections between the thermoelectric module 90 and the flexible circuit panel 56, and between the thermoelectric module 90 and any heat sinks 52. The bottom layer 98 and the first and second TM conductors 100, 102 may be attached to the base 92 and to respective circuit conductors 58 or heat sinks 52 with solder connections and/or other adhesives, as noted above.

In some embodiments, the first and second thermoelectric elements 14, 16 may have generally the same thickness as the base 92 such that top surfaces 20, 22 of the first and second thermoelectric elements 14, 16 are coplanar or nearly coplanar with a top surface of the base 92. In other embodiments, the first and second thermoelectric elements 14, 16 are slightly shorter than the outermost top and/or bottom surfaces of the base 92 to enable the first and second TM conductors 100, 102 and/or the bottom layer 98 to be partly or completely recessed within the base 92.

A further embodiment of a thermoelectric module 110 is illustrated in Figure 8. This embodiment illustrates one possible variation or combination which may be made. Specifically, the thermoelectric module 110 includes first and second link layers 78, 80 on the top surface 24 of the base 12, as described above. In this embodiment, the thermoelectric module 110 includes an integrated bottom layer 114. The integrated bottom layer 114 may be bonded to the base 12 and achieve the functions of both a bottom layer and a third link layer, as described above. Specifically, the integrated bottom layer 114 may comprise a metal, such as copper or aluminum, which is bonded to the base 12. The integrated bottom layer 114 may cover a substantial portion of the bottom surface 34 of the base 12, including the first and second apertures 74, 76. As a result, the integrated bottom layer 114 and the first and second apertures 74, 76 define first and second cavities for receiving the first and second thermoelectric elements 14, 16. The first and second thermoelectric elements 14, 16 may be placed in the first and second apertures 74,76 and coupled to the integrated bottom layer 114 using solder and/or electrically conductive adhesive connections. The first and second link layers 78, 80 may be configured as shown in Figures 5A and 5B and used to connect the thermoelectric module 110 to the flexible circuit panel 56 by solder and/or electrically conductive adhesive connections. The integrated bottom layer 114, the first and second link layers 78, 80, and the thermoelectric elements 14, 16 may be attached to respective circuit conductors 58 or heat sinks with solder connections and/or other adhesives, as noted above.

It will be appreciated that different manufacturing methods and steps may be involved in producing the thermoelectric modules 10, 70, 90, 110 described herein depending on the combination of layers and conductors used. For example, if there is an integrated bottom layer 114 bonded to the base 12 as shown in Figure 8, solder and/or adhesive may be placed on the top surface of the integrated bottom layer 114 within the first and second cavities, and then the first and second thermoelectric elements 14, 16 may be placed in the first and second cavities to be soldered or adhered to the integrated bottom layer 114. In the embodiment illustrated in Figures 4, 5A, 5B and 6, solder paste may be applied to sections on the top surface of the bottom layer 40, and then the base 12 and thermoelectric elements 14, 16 may be placed on the solder paste. As a result, the base 12 and thermoelectric elements 14, 16 may be affixed to the bottom layer 40 during the same solder reflow process. Alternatively, in some embodiments, the thermoelectric modules may be assembled or constructed by mounting components on the flexible circuit panel 56 of a flexible thermoelectric circuit assembly 50, 72. The methods and order of assembly and manufacture do not limit or alter the resulting thermoelectric modules and flexible thermoelectric circuit assemblies described herein.

The solder and/or adhesive connections for the bottom layer 40, 98 or the integrated bottom layer 114; the first, second and third link layers 78, 80, 84 which are bonded to the base 12; and/or the first and second TM conductors 100, 102; as well as the solder and/or adhesive connections between the thermoelectric module 10, 70, 90, 110 and the circuit conductors 58 on the flexible circuit panel 56 reduces physical loading on the first and second thermoelectric elements 14, 16. By reducing the physical loading, the size of the first and second thermoelectric elements 14, 16 may be reduced while still achieving an acceptable thermoelectric performance. A reduced size of the thermoelectric elements 14, 16, and thus a reduced size of the thermoelectric module 10, 70, 90, 110, also results in reduced costs and greater flexibility for the flexible thermoelectric circuit assembly 50, 72.

It also will be appreciated that in all embodiments of the thermoelectric modules 10, 70, 90, 110 described herein, each of the bottom layers 40, 98, the integrated bottom layer 114, the first and second TM conductors 100, 102, and the first, second, and third link layers 74, 78, 84 of the thermoelectric modules, as well as the circuit conductors 58 of the flexible circuit panel 56, may be sized to achieve the required electrical conductivity, to optimize the thermal conductivity, and/or to optimize the physical connectivity of the components. The thermoelectric elements 14, 16, however, do not need to be completely covered by the bottom layers 40, 98, the integrated bottom layer 114, the first and second TM conductors 100, 102, and/or the respective circuit conductors 58 of the flexible circuit panel 56 in order to operate.

Figures 9 to 11 illustrate alternative flexible thermoelectric circuit assemblies and various applications of the thermoelectric modules 10, 70, 90, 110 described herein. The flexible thermoelectric circuit assembly 120 illustrated in Figure 9 includes a flexible circuit panel 56 and multiple thermoelectric modules according to an embodiment described herein. Each thermoelectric module is mounted across two circuit conductors 58 and a heat sink 122 is attached to each thermoelectric module 10, 70, 90, 110. The heat sink 122 may be a flexible heat sink or, since the thermoelectric modules are relatively small, a rigid heat sink formed of extruded aluminum may be used without sacrificing the flexibility of the flexible thermoelectric circuit assembly 120. The fins of the heat sink 122 may be different shapes other than the rectangular shapes shown and the fins also may be closed or open-ended. The fins of the heat sinks 122 also may flex and change shape with the use of the flexible thermoelectric circuit assembly 120.

The locations of the thermoelectric modules 10, 70, 90, 110 and the connectivity created by circuit conductors 58 of the flexible circuit panel 56 may be configured to target the heating and/or cooling of a specific vehicle seat based on the size of the seat and the pressure distribution created by an occupant of the seat. Although the thermoelectric modules 10, 70, 90, 110 described herein may be used for heating and/or cooling applications by changing the current flow through the flexible thermoelectric circuit assembly 50, 72, 120, it will be appreciated that other means may exist for heating applications. Thus, in some embodiments, the thermoelectric modules 10, 70, 90, 110 and flexible thermoelectric circuit assemblies 50, 72, 120 described herein may target primarily cooling applications or applications in which heating and cooling for specific temperature control are required. In some embodiments, a resistive heating element may be combined with and/or controlled by the flexible thermoelectric circuit assembly 50, 72, 120 to provide heat more effectively. For example, a continuous loop of conductive material (not shown) may be included to add a resistive heating element to a flexible thermoelectric circuit assembly.

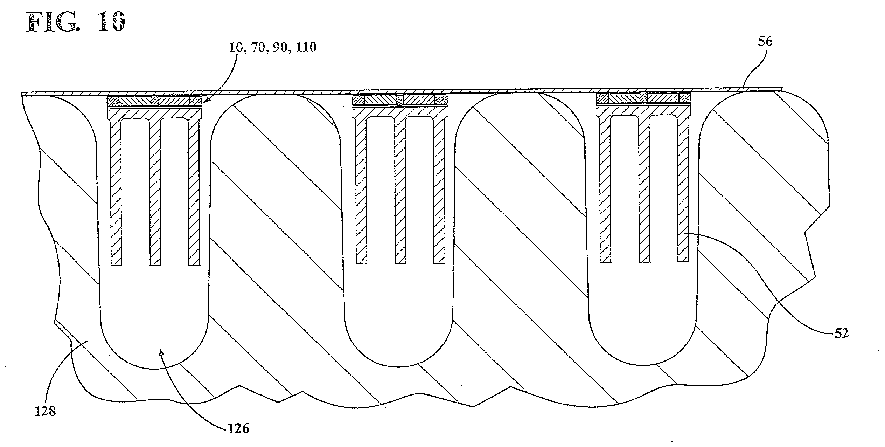

Figure 9 illustrates a bottom view of the flexible thermoelectric circuit assembly 120. When inverted and mounted to a vehicle seat, the thermoelectric modules 10, 70, 90, 110 and heat sinks 122 attached thereto, may be configured to extend downwardly within channels of the seat cushion or padding. As shown in the embodiment of Figure 10, for example, each thermoelectric module 10, 70, 90, 110 is mounted to the flexible circuit panel 56 such that, when assembled with a seat cushion or padding, each thermoelectric module 10, 70, 90, 110 sits within a channel 126 defined by padding 128 of the seat assembly. A heat sink 52 is mounted to each thermoelectric module 10, 70, 90, 110 and the fins of each heat sink 52 extend within each channel 126.

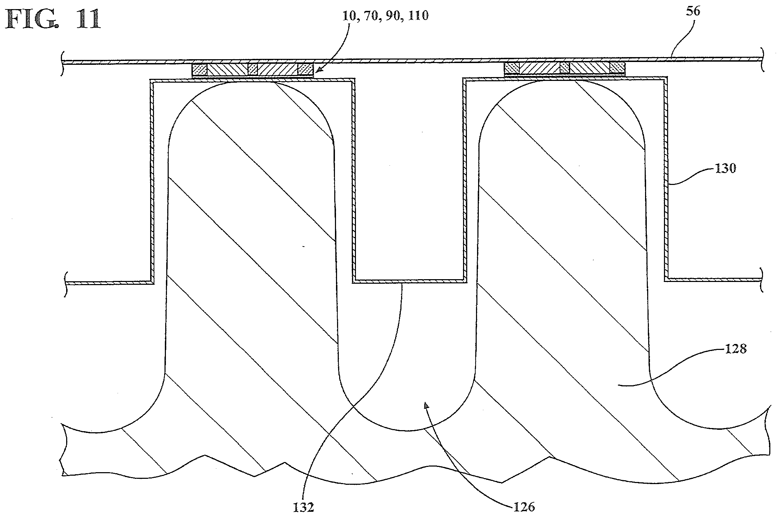

Alternatively, as shown in the embodiment of Figure 11, some or all of the thermoelectric modules 10, 70, 90, 110 may be configured to rest upon or be supported by the padding 128 of the seat assembly. Heat sinks 130 may be attached to the thermoelectric modules 10, 70, 90, 110 and configured with one or more fins 132 extending within the channels 126 defined by the padding 128. The heat sinks 130 may include a single fin 132 within each channel 126. Alternatively, one or more fins or folded fins of a rigid or flexible heat sink may extend within each channel 126.

In the embodiments shown in Figures 10 and 11, air may be forced or drawn through the channels 126 by fans or blowers (not shown) to further accelerate the cooling of the seat by removing excess heat from the heat sinks 52, 130.

The invention has been described in an illustrative manner. Many modifications and variations of the present invention are possible in light of the above teachings. It is, therefore, to be understood that within the scope of the appended claims, the invention may be practiced other than as specifically described.

## Claims

1. A thermoelectric module (10) comprising:
a base (12);
first and second thermoelectric elements (14, 16) set in the base (12) and electrically isolated by the base (12), wherein the base (12) defines a first aperture (15) extending through the base (12) for receiving the first thermoelectric element (14) and a second aperture (17) extending through the base (12) for receiving the second thermoelectric element (16) ;
a bottom layer (40) coupled to: a bottom surface (34) of the base (12), a bottom surface (30) of the first thermoelectric element (14), and a bottom surface (32) of the second thermoelectric element (16), the bottom layer (40) electrically connecting the first and second thermoelectric elements (14, 16);
a first link layer (78) coupled to a top surface (24) of the base (12) and partially surrounding the first aperture (15); and
a second link layer (80) coupled to the top surface (24) of the base (12), partially surrounding the second aperture (17) and electrically isolated from the first link layer (78).

2. The thermoelectric module (10) of claim 1, wherein the bottom layer (40) comprises an electrically conductive material.

3. The thermoelectric module (10) of claim 2, wherein the bottom layer (40) is coupled to the bottom surfaces (30, 32) of the first and second thermoelectric elements (14, 16) by an electrically conductive adhesive or a solder connection, and wherein the bottom layer (40) is coupled to the bottom surface (34) of the base (12) with an adhesive.

4. The thermoelectric module (10) of claim 1, wherein the bottom layer (40) covers substantially all of the bottom surface (34) of the base (12), the bottom surface (30) of the first thermoelectric element (14), and the bottom surface (32) of the second thermoelectric element (16); and/or
wherein the base (12) is molded to surround the first and second thermoelectric elements (14, 16); and/or
wherein the base (12) is rigid or semirigid; and/or
wherein the base (12) encloses each of the first and second thermoelectric elements (14, 16); and/or
wherein the base (12) has a thermal conductivity substantially lower than thermal conductivities of the first and second thermoelectric elements (14, 16); and/or
wherein the first thermoelectric element comprises a P-type thermoelectric element and wherein the second thermoelectric element comprises an N-type thermoelectric element; and/or
wherein the first and second thermoelectric elements (14, 16) have substantially the same thickness as the base (12); and/or
wherein the bottom layer (40) comprises a heat sink.

5. The thermoelectric module (10) of claim 1, further comprising:
a first thermoelectric module (TM) conductor (58x) adjacent a top surface (24) of the base (12) opposite the bottom surface (34) of the base (12), the first conductor (58x) coupled to the first thermoelectric element (14); and
a second TM conductor (58y) adjacent the top surface (24) of the base (12), the second conductor (58y) coupled to the second thermoelectric element (16) and electrically isolated from the first TM conductor (58x).

6. The thermoelectric module (10) of claim 5,
wherein the first TM conductor (58x) comprises a layer of conductive material covering a top surface (20) of the first thermoelectric element (14); and
wherein the second TM conductor (58y) comprises a layer of conductive material covering a top surface (22) of the second thermoelectric element (16) and electrically isolated from the first conductor (58x).

7. The thermoelectric module (10) of claim 6, wherein the first conductor (58x) is affixed to the top surface (20) of the first thermoelectric element (14) by an electrically conductive adhesive or a solder connection; and wherein the second conductor (58y) is affixed to the top surface (22) of the second thermoelectric element (16) by an electrically conductive adhesive or a solder connection; and/or
wherein the first conductor (58x) further covers a first portion of the top surface (24) of the base (12) surrounding the first thermoelectric element (14), and the second conductor (58y) further covers a second portion of the top surface (24) of the base (12) surrounding the second thermoelectric element (16).

8. The thermoelectric module (10) of claim 1, further comprising a third link layer (84) between the bottom layer (40) and the bottom surface (34) of the base (12), the third link layer (84) surrounding the first and second apertures (15, 17).

9. The thermoelectric module (10) of claim 8, wherein the third link layer (84) covers substantially all of the bottom surface (34) of the base (12); and/or
wherein the third link layer (84) comprises an electrically conductive material which is bonded to the base (12), and wherein the bottom layer (40) is connected to the third link layer (84) by a solder connection or by an electrically conductive adhesive.

10. The thermoelectric module (10) of claim 1, further comprising a heat sink (52) coupled to the bottom layer (40).

11. The thermoelectric module (10) of claim 10, further comprising a dielectric layer (54) between the heat sink (52) and the bottom layer (40); and/or
wherein the heat sink (52) comprises a flexible heat sink, a graphite heat sink, an extruded aluminium heat sink, or a copper heat sink.

## Patentansprüche

1. Thermoelektrisches Modul (10), das aufweist:
eine Basis (12);
erste und zweite thermoelektrische Elemente (14, 16), die in die Basis (12) eingesetzt und durch die Basis (12) elektrisch isoliert sind, wobei die Basis (12) eine erste Öffnung (15), die sich durch die Basis (12) erstreckt, zum Aufnehmen des ersten thermoelektrischen Elements (14) und eine zweite Öffnung (17), die sich durch die Basis (12) erstreckt, zum Aufnehmen des zweiten thermoelektrischen Elements (16) definiert;
eine untere Schicht (40), die gekoppelt ist mit: einer unteren Oberfläche (34) der Basis (12), einer unteren Oberfläche (30) des ersten thermoelektrischen Elements (14) und einer unteren Oberfläche (32) des zweiten thermoelektrischen Elements (16), wobei die untere Schicht (40) die ersten und zweiten thermoelektrischen Elemente (14, 16) elektrisch verbindet;
eine erste Verbindungsschicht (78), die mit einer oberen Oberfläche (24) der Basis (12) gekoppelt ist und die erste Öffnung (15) teilweise umgibt; und
eine zweite Verbindungsschicht (80), die mit der oberen Oberfläche (24) der Basis (12) gekoppelt ist, die zweite Öffnung (17) teilweise umgibt und von der ersten Verbindungsschicht (78) elektrisch isoliert ist.

2. Thermoelektrisches Modul (10) nach Anspruch 1, wobei die untere Schicht (40) ein elektrisch leitfähiges Material aufweist.

3. Thermoelektrisches Modul (10) nach Anspruch 2, wobei die untere Schicht (40) an die unteren Oberflächen (30, 32) der ersten und zweiten thermoelektrischen Elemente (14, 16) durch einen elektrisch leitfähigen Klebstoff oder eine Lötverbindung gekoppelt ist und wobei die untere Schicht (40) mit einem Klebstoff an die untere Oberfläche (34) der Basis (12) gekoppelt ist.

4. Thermoelektrisches Modul (10) nach Anspruch 1, wobei die untere Schicht (40) im Wesentlichen alles der unteren Oberfläche (34) der Basis (12), der unteren Oberfläche (30) des ersten thermoelektrischen Elements (14) und der unteren Oberfläche (32) des zweiten thermoelektrischen Elements (16) bedeckt; und/oder
wobei die Basis (12) dafür geformt ist, die ersten und zweiten thermoelektrischen Elemente (14, 16) zu umgeben; und/oder
wobei die Basis (12) starr oder halbstarr ist; und/oder
wobei die Basis (12) jedes der ersten und zweiten thermoelektrischen Elemente (14, 16) umschließt; und/oder
wobei die Basis (12) eine thermische Leitfähigkeit aufweist, die wesentlich geringer ist als thermische Leitfähigkeiten der ersten und zweiten thermoelektrischen Elemente (14, 16); und/oder
wobei das erste thermoelektrische Element ein P-leitendes thermoelektrisches Element umfasst und wobei das zweite thermoelektrische Element ein N-leitendes thermoelektrisches Element umfasst; und/oder
wobei die ersten und zweiten thermoelektrischen Elemente (14, 16) im Wesentlichen die gleiche Dicke wie die Basis (12) aufweisen; und/oder
wobei die untere Schicht (40) einen Kühlkörper aufweist.

5. Thermoelektrisches Modul (10) nach Anspruch 1, das ferner aufweist:
einen ersten TM(thermoelektrisches Modul)-Leiter (58x) neben einer oberen Oberfläche (24) der Basis (12) gegenüber der unteren Oberfläche (34) der Basis (12), wobei der erste Leiter (58x) an das erste thermoelektrische Element (14) gekoppelt ist; und
einen zweiten TM-Leiter (58y) neben der oberen Oberfläche (24) der Basis (12), wobei der zweite Leiter (58y) an das zweite thermoelektrische Element (16) gekoppelt und von dem ersten TM-Leiter (58x) elektrisch isoliert ist.

6. Thermoelektrisches Modul (10) nach Anspruch 5,
wobei der erste TM-Leiter (58x) eine Schicht leitfähigen Materials aufweist, die eine obere Oberfläche (20) des ersten thermoelektrischen Elements (14) bedeckt; und
wobei der zweite TM-Leiter (58y) eine Schicht leitfähigen Materials aufweist, die eine obere Oberfläche (22) des zweiten thermoelektrischen Elements (16) bedeckt und von dem ersten Leiter (58x) elektrisch isoliert ist.

7. Thermoelektrisches Modul (10) nach Anspruch 6, wobei der erste Leiter (58x) an der oberen Oberfläche (20) des ersten thermoelektrischen Elements (14) durch einen elektrisch leitfähigen Klebstoff oder eine Lötverbindung befestigt ist; und wobei der zweite Leiter (58y) an der oberen Oberfläche (22) des zweiten thermoelektrischen Elements (16) durch einen elektrisch leitfähigen Klebstoff oder eine Lötverbindung befestigt ist; und/oder
wobei der erste Leiter (58x) ferner einen ersten Abschnitt der oberen Oberfläche (24) der Basis (12) bedeckt, die das erste thermoelektrische Element (14) umgibt, und der zweite Leiter (58y) ferner einen zweiten Abschnitt der oberen Oberfläche (24) der Basis (12) bedeckt, die das zweite thermoelektrische Element (16) umgibt.

8. Thermoelektrisches Modul (10) nach Anspruch 1, das ferner eine dritte Verbindungsschicht (84) zwischen der unteren Schicht (40) und der unteren Oberfläche (34) der Basis (12) aufweist, wobei die dritte Verbindungsschicht (84) die ersten und zweiten Öffnungen (15, 17) umgibt.

9. Thermoelektrisches Modul (10) nach Anspruch 8, wobei die dritte Verbindungsschicht (84) im Wesentlichen alles der unteren Oberfläche (34) der Basis (12) bedeckt; und/oder
wobei die dritte Verbindungsschicht (84) ein elektrisch leitfähiges Material aufweist, das an die Basis (12) gebondet ist, und wobei die untere Schicht (40) mit der dritten Verbindungsschicht (84) durch eine Lötverbindung oder durch einen elektrisch leitfähigen Klebstoff verbunden ist.

10. Thermoelektrisches Modul (10) nach Anspruch 1, das ferner einen Kühlkörper (52) aufweist, der an die untere Schicht (40) gekoppelt ist.

11. Thermoelektrisches Modul (10) nach Anspruch 10, das ferner eine dielektrische Schicht (54) zwischen dem Kühlkörper (52) und der unteren Schicht (40) aufweist; und/oder
wobei der Kühlkörper (52) einen flexiblen Kühlkörper, einen Graphitkühlkörper, einen Kühlkörper aus extrudiertem Aluminium oder einen Kupferkühlkörper umfasst.

## Revendications

1. Module thermoélectrique (10) comprenant :
une base (12) ;
un premier et un second élément thermoélectrique (14, 16) placés dans la base (12) et électriquement isolés par la base (12),
dans lequel la base (12) définit une première ouverture (15) s'étendant à travers la base (12) destinée à recevoir le premier élément thermoélectrique (14) et une seconde ouverture (17) s'étendant à travers la base (12) destinée à recevoir le second élément thermoélectrique (16) ;
une couche de fond (40) couplée à : une surface de fond (34) de la base (12), une surface de fond (30) du premier élément thermoélectrique (14), et une surface de fond (32) du second élément thermoélectrique (16), la couche de fond (40) connectant électriquement le premier et le second élément thermoélectrique (14, 16) ;
une première couche de liaison (78) couplée à une surface supérieure (24) de la base (12) et entourant partiellement la première ouverture (15) ; et
une deuxième couche de liaison (80) couplée à la surface supérieure (24) de la base (12), entourant partiellement la seconde ouverture (17) et isolée électriquement de la première couche de liaison (78).

2. Module thermoélectrique (10) selon la revendication 1, dans lequel la couche de fond (40) comprend un matériau électriquement conducteur.

3. Module thermoélectrique (10) selon la revendication 2, dans lequel la couche de fond (40) est couplée aux surfaces de fond (30, 32) du premier et du second élément thermoélectrique (14, 16) par un adhésif électriquement conducteur ou une connexion soudée, et dans lequel la couche de fond (40) est couplée à la surface de fond (34) de la base (12) avec un adhésif.

4. Module thermoélectrique (10) selon la revendication 1, dans lequel la couche de fond (40) couvre sensiblement l'ensemble de la surface de fond (34) de la base (12), de la surface de fond (30) du premier élément thermoélectrique (14), et de la surface de fond (32) du second élément thermoélectrique (16) ; et/ou
dans lequel la base (12) est moulée pour entourer le premier et le second élément thermoélectrique (14, 16) ; et/ou
dans lequel la base (12) est rigide ou semi-rigide ; et/ou
dans lequel la base (12) enferme chacun du premier et du second élément thermoélectrique (14, 16) ; et/ou dans lequel la base (12) a une conductivité thermique sensiblement inférieure aux conductivités thermiques du premier et du second élément thermoélectrique (14, 16) ; et/ou
dans lequel le premier élément thermoélectrique comprend un élément thermoélectrique de type P et dans lequel le second élément thermoélectrique comprend un élément thermoélectrique de type N ; et/ou
dans lequel le premier et le second élément thermoélectrique (14, 16) ont sensiblement la même épaisseur que la base (12) ; et/ou
dans lequel la couche de fond (40) comprend un dissipateur thermique.

5. Module thermoélectrique (10) selon la revendication 1, comprenant en outre :
un premier conducteur (58x) de module thermoélectrique (TM) adjacent à une surface supérieure (24) de la base (12) opposée à la surface de fond (34) de la base (12), le premier conducteur (58x) étant couplé au premier élément thermoélectrique (14) ; et
un second conducteur (58y) adjacent à la surface supérieure (24) de la base (12), le second conducteur (58y) étant couplé au second élément thermoélectrique (16) et électriquement isolé vis-à-vis du premier conducteur TM (58x).

6. Module thermoélectrique (10) selon la revendication 5,
dans lequel le premier conducteur TM (58x) comprend une couche de matériau conducteur couvrant une surface supérieure (20) du premier élément thermoélectrique (14) ; et
dans lequel le second conducteur TM (58y) comprend une couche de matériau conducteur couvrant une surface supérieure (22) du second élément thermoélectrique (16) et électriquement isolée vis-à-vis du premier conducteur (58x).

7. Module thermoélectrique (10) selon la revendication 6, dans lequel le premier conducteur (58x) est fixé à la surface supérieure (20) du premier élément thermoélectrique (14) par un adhésif électriquement conducteur ou une connexion soudée ; et dans lequel le second conducteur (58y) est fixé à la surface supérieure (22) du second élément thermoélectrique (16) par un adhésif électriquement conducteur ou une connexion soudée ; et/ou
dans lequel le premier conducteur (58x) couvre en outre une première portion de la surface supérieure (24) de la base (12) entourant le premier élément thermoélectrique (14), et le second conducteur (58y) couvre en outre une seconde portion de la surface supérieure (24) de la base (12) entourant le second élément thermoélectrique (16).

8. Module thermoélectrique (10) selon la revendication 1, comprenant en outre une troisième couche de liaison (84) entre la couche de fond (40) et la surface de fond (34) de la base (12), la troisième couche de liaison (84) entourant la première et la deuxième ouverture (15, 17).

9. Module thermoélectrique (10) selon la revendication 8, dans lequel la troisième couche de liaison (84) couvre sensiblement l'ensemble de la surface de fond (34) de la base (12) ; et/ou
dans lequel la troisième couche de liaison (84) comprend un matériau électriquement conducteur qui est jointoyé à la base (12), et dans lequel la couche de fond (40) est connectée à la troisième couche de liaison (84) par une connexion soudée ou par un adhésif électriquement conducteur.

10. Module thermoélectrique (10) selon la revendication 1, comprenant en outre un dissipateur thermique (52) couplé à la couche de fond (40).

11. Module thermoélectrique (10) selon la revendication 10, comprenant en outre une couche diélectrique (54) entre le dissipateur thermique (52) et la couche de fond (40) ; et/ou
dans lequel le dissipateur thermique (52) comprend un dissipateur thermique flexible, un dissipateur thermique en graphite, un dissipateur thermique en aluminium extrudé, ou un dissipateur thermique en cuivre.
